(19) **Europäisches Patentamt / European Patent Office / Office européen des brevets**

(11) **EP 1 619 788 B1**

(12) **FASCICULE DE BREVET EUROPEEN**

(45) Date de publication et mention
de la délivrance du brevet:
**25.07.2007 Bulletin 2007/30**

(51) Int Cl.:
***H03B 5/04*** (2006.01)

(21) Numéro de dépôt: **05354024.1**

(22) Date de dépôt: **09.06.2005**

(54) **Oscillateur contrôlé en tension à capacité linéaire**

Spannungsgesteuerter Oszillator mit linearer Kapazität

Voltage controlled oscillator with linear capacitance

(84) Etats contractants désignés:
**AT BE BG CH CY CZ DE DK EE ES FI FR GB GR HU IE IS IT LI LT LU MC NL PL PT RO SE SI SK TR**

(30) Priorité: **22.07.2004 FR 0408121**

(43) Date de publication de la demande:
**25.01.2006 Bulletin 2006/04**

(73) Titulaire: **COMMISSARIAT A L'ENERGIE ATOMIQUE**
**75752 Paris (FR)**

(72) Inventeurs:
• **Geynet, Lionel**
**30250 Fontanes (FR)**

• **de Foucauld, Emeric**
**38170 Seyssinet (FR)**

(74) Mandataire: **Jouvray, Marie-Andrée et al
Cabinet Hecké,
World Trade Center - Europole,
5, place Robert Schuman,
B.P. 1537
38025 Grenoble Cedex 1 (FR)**

(56) Documents cités:
**US-B1- 6 292 065      US-B1- 6 657 509**

## Description

## Domaine technique de l'invention

L'invention concerne un oscillateur contrôlé en tension comportant un amplificateur et un réseau oscillant comportant une inductance et au moins des premier et second condensateurs variables ayant chacun une capacité variant en fonction de sa tension de commande.

## État de la technique

Un oscillateur contrôlé en tension (« Voltage Controlled Oscillator : VCO ») fournit des signaux oscillants dont la fréquence varie en fonction d'une tension de contrôle Uc. Le gain de l'oscillateur contrôlé en tension est défini par le rapport K = F/Uc entre la fréquence F de ses signaux de sortie et la tension de contrôle Uc appliquée sur son entrée. Le gain varie généralement en fonction de la tension de contrôle Uc appliquée.

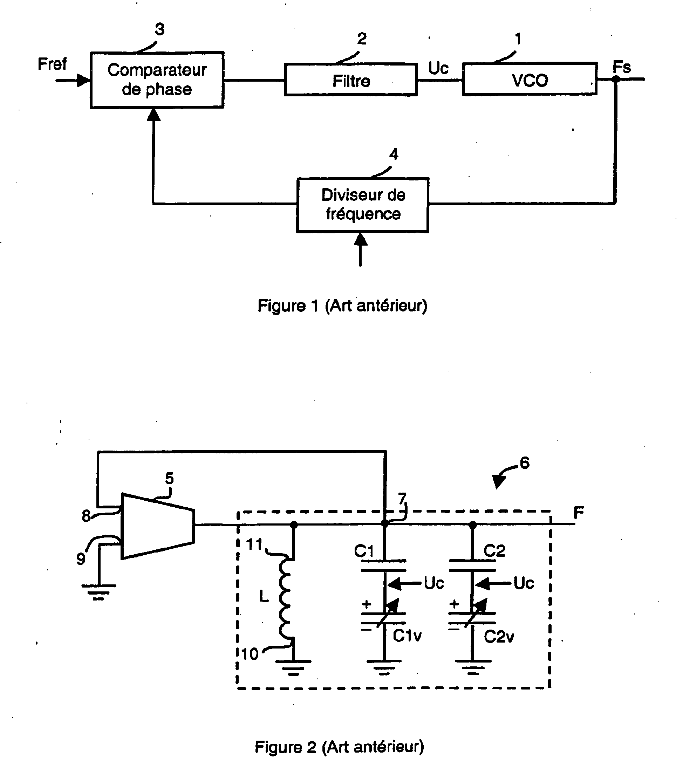

Les oscillateurs contrôlés en tension sont souvent utilisés dans des boucles à verrouillage de phase, comme représenté à la figure 1. Une telle boucle comporte classiquement un oscillateur 1 contrôlé en tension, dont l'entrée est connectée, par l'intermédiaire d'un filtre 2, à la sortie d'un comparateur de phase 3 et dont la sortie, qui constitue la sortie de la boucle, est connectée à une première entrée du comparateur de phase 3, éventuellement par l'intermédiaire d'un diviseur de fréquence 4. Des signaux d'horloge, ayant une fréquence de référence Fref prédéterminée et par exemple fournis par un oscillateur à quartz, sont appliqués sur une seconde entrée du comparateur de phase 3.

La tension de contrôle Uc de l'oscillateur est ainsi fonction de la différence entre la fréquence Fs des signaux de sortie de l'oscillateur 1, éventuellement affectée d'un coefficient de division, et de la fréquence de référence Fref. Quand la boucle est verrouillée, la fréquence Fs de sortie est ainsi égale à la fréquence de référence Fref ou à un multiple de celle-ci.

Une telle boucle à verrouillage de phase est utilisée dans de nombreux circuits nécessitant une synthèse de fréquence, en particulier dans le domaine des radio-fréquences, pour la réception de signaux modulés. Plusieurs standards de transmission, par exemple des standards de type GSM, GPS ou DCS, des standards utilisant la technologie Bluetooth ou un réseau local sans fil (WLAN), sont souvent utilisés dans un même récepteur, notamment dans les téléphones portables. Il est alors souhaitable de pouvoir passer rapidement d'un standard à une autre, par exemple d'un standard de type GSM à un standard de type Bluetooth.

Le passage d'un standard à l'autre, c'est-à-dire d'une bande de fréquence à une autre, peut provoquer le décrochage de la boucle à verrouillage de phase, c'est-à-dire que l'oscillateur contrôlé en tension ne fournit plus aucun signal. Afin d'éviter le décrochage de la boucle, on cherche à construire des oscillateurs 1 dont les variations de la fréquence F avec la tension de contrôle Uc sont linéaires et monotones, c'est-à-dire dont le gain K = F/Uc est une constante.

Un oscillateur contrôlé en tension comporte typiquement un amplificateur et un réseau oscillant de type LC. Le réseau oscillant est très important, car de sa conception dépendent les performances du circuit, par exemple le bruit de phase, le coefficient de qualité, la fréquence d'oscillation, etc... De manière générale, la fréquence F de sortie de l'oscillateur contrôlé en tension est fonction de la valeur d'une l'inductance L du réseau oscillant et de la capacité totale Ct du réseau oscillant :

$$F = 1/(2\pi\sqrt{L \times Ct(Uc)}).$$

Dans la plupart des cas, la capacité totale Ct et la fréquence d'oscillation F varient de manière non-linéaire avec la tension de contrôle.

Actuellement, deux techniques principales sont utilisées pour la conception d'oscillateurs contrôlés en tension ayant une caractéristique capacité/tension linéaire.

Une première technique consiste à utiliser un condensateur variable dans une gamme restreinte de la tension de contrôle Uc, dans laquelle la capacité varie linéairement. Cependant, ceci nécessite de réduire la plage de variation de la tension de contrôle. Cette technique permet d'obtenir une caractéristique capacité/tension linéaire mais le gain de l'oscillateur est, dans ce cas, très grand et le bruit de phase est ainsi important. De plus, la plage de tension étant réduite, l'asservissement d'une boucle à verrouillage de phase est plus difficile à réaliser et une stabilité de la boucle est difficile à atteindre.

Une deuxième technique consiste à polariser différemment des condensateurs variables connectés en parallèle. Cette technique permet d'obtenir une caractéristique capacité/tension linéaire. Cependant, cette technique est difficile à réaliser.

Le brevet US6396356 décrit un oscillateur 1 contrôlé en tension comportant plusieurs condensateurs variables dont les parties linéaires des caractéristiques capacité/tension sont utilisées successivement. Comme illustré à la figure 2, cet oscillateur 1 comporte un amplificateur 5 et un réseau oscillant 6 de type LC comportant une inductance L. Une première borne 10 de l'inductance L est connectée à la masse et une seconde borne 11 de l'inductance est connectée à la sortie de l'amplificateur 5. La seconde borne 11 de l'inductance L est également connectée à une borne 7 de rétroaction reliée à une première entrée 8 de l'amplificateur 5. Une seconde entrée 9 de l'amplificateur est connectée à la masse. La borne 7 de rétroaction est reliée à la masse par l'intermédiaire d'un premier ensemble constitué par un premier condensateur variable Cv1 et un premier condensateur à capacité fixe C1 connectés en série, d'une part, et d'un second ensemble constitué par un second condensateur variable Cv2 et un second condensateur à capacité fixe C2 connectés en série, d'autre part. Ces deux ensembles sont ainsi disposés en parallèle entre la borne 7 de rétroaction et la masse. La tension de contrôle Uc peut être appliquée à une borne disposée entre le premier condensateur variable Cv1 et le premier condensateur à capacité fixe C1, et/ou à une borne disposée entre le second condensateur variable Cv2 et le second condensateur à capacité fixe C2. Lors d'une commutation d'un condensateur variable à l'autre, la tension de contrôle Uc varie de manière discontinue, ce qui peut provoquer le décrochage d'une boucle à verrouillage de phase comportant cet oscillateur. Par ailleurs, cet oscillateur présente un écart important entre les valeurs minimale et maximale de la capacité totale et, ainsi, un bruit de phase important.

Le document US6292065 décrit un oscillateur contrôlé en tension comportant un module oscillant de type LC. Le module oscillant comprend deux inductances, une source de courant et deux transistors de rétroaction, qui constituent un amplificateur différentiel. Le module oscillant comporte deux bornes d'entrée. Un ensemble de premiers condensateurs variables est connecté, entre les deux bornes d'entrée, en parallèle avec un ensemble de seconds condensateurs variables. Lorsqu'une tension de mode commun est appliquée aux bornes d'entrée, la capacité d'une paire de premiers condensateurs variables augmente et la capacité d'une paire de seconds condensateurs variables diminue. Ceci annule l'effet de la tension de mode commun sur une fréquence de sortie du module oscillant. Par contre, une différence de tension appliquée aux bornes d'entrée permet de modifier la fréquence de sortie du module oscillant.

Le document US6657509 décrit un oscillateur de type LC. Deux condensateurs variables sont contrôlés chacun par une différence de potentiel appliquée entre des bornes de contrôle. Les condensateurs variables sont, de plus, connectés respectivement à deux bornes de sortie. Chaque condensateur variable est constitué par deux transistors de type MOS constituant eux-mêmes des condensateurs variables. Comme dans le document US6292065, un ensemble de deux transistors est ainsi connecté entre les bornes de sortie, en parallèle avec un ensemble constitué par les deux autres transistors. La capacité des transistors augmente avec la tension de contrôle.

**Objet de l'invention**

L'invention a pour but de surmonter ces inconvénients et, plus particulièrement, de réaliser un oscillateur contrôlé en tension ayant une caractéristique capacité/tension linéaire et monotone, permettant d'obtenir un gain continue et monotone et dont le bruit de phase est réduit.

Selon l'invention, ce but est atteint par les revendications annexées et, plus particulièrement, par le fait que les premier et second condensateurs variables sont connectés en série, la capacité de l'un des condensateurs variables variant dans le même sens que sa tension de commande et la capacité de l'autre condensateur variable variant en sens inverse par rapport à sa tension de commande.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

La figure 1 illustre schématiquement une boucle à verrouillage de phase de type classique.
La figure 2 illustre un oscillateur contrôlé en tension selon l'art antérieur.
Les figures 3 et 4 représentent deux modes particuliers de réalisation d'un oscillateur selon l'invention.
La figure 5 illustre les variations de la capacité totale d'un oscillateur selon la figure 3 en fonction de sa tension de contrôle Uc ainsi que les variations de la capacité de chacun des condensateurs variables en fonction de sa tension de commande.
Les figures 6 et 7 représentent deux modes particuliers de réalisation d'un oscillateur selon l'invention.

**Description de modes particuliers de réalisation**

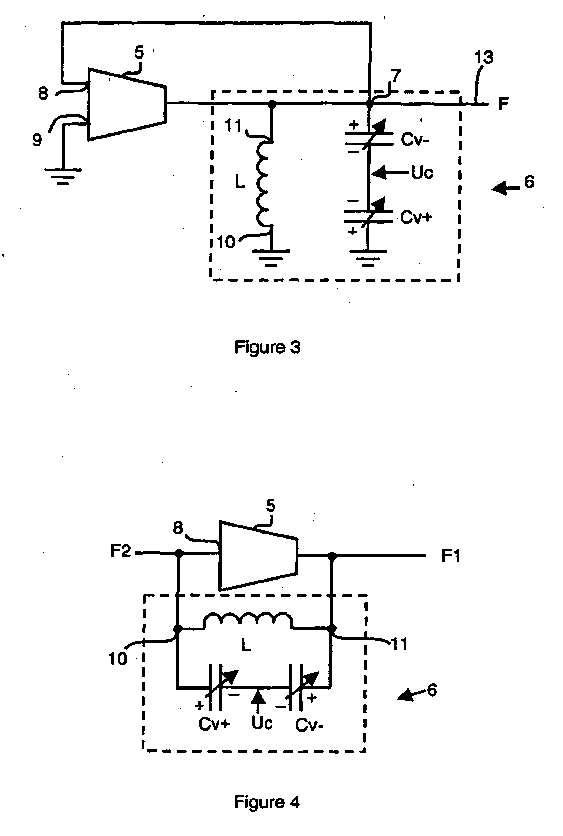

L'oscillateur 1 contrôlé en tension représenté à la figure 3 est un oscillateur à sortie unique 13 qui comporte un amplificateur 5 et un réseau oscillant 6, de type LC, connectés selon la figure 2.

Ainsi, la première borne 10 de l'inductance L est connectée à la masse et la seconde borne 11 de l'inductance L est connectée à la sortie de l'amplificateur 5. La seconde borne 11 de l'inductance L est également connectée à la borne 7 de rétroaction reliée à la première entrée 8 de l'amplificateur 5. La seconde entrée 9 de l'amplificateur est connectée à la masse.

Le réseau oscillant 6 comporte un premier condensateur variable Cv+ et un second condensateur variable Cv- connectés en série entre la borne 7 de rétroaction et la masse. Dans le mode de réalisation particulier représenté, l'inductance L est ainsi connectée en parallèle avec les premier (Cv+) et second (Cv-) condensateurs variables. Une borne positive du premier condensateur variable Cv+ est connectée à la masse et une borne positive du second condensateur variable Cv- est connectée à la borne 7 de rétroaction. Sur la figure 3, les premier et second condensateurs variables Cv+ et Cv- sont disposés en opposition.

Sur la figure 3, une borne négative du premier condensateur variable Cv+ est connectée à une borne négative du second condensateur variable Cv-. Les premier Cv+ et second Cv- condensateurs variables comportent ainsi une borne commune, reliée à leurs bornes négatives respectives. La tension de contrôle Uc de l'oscillateur 1 est appliquée à la borne commune aux condensateurs variables Cv+ et Cv-.

La capacité du premier condensateur variable Cv+ varie dans le même sens que sa tension de commande, tandis que la capacité du second condensateur variable Cv- varie en sens inverse par rapport à sa tension de commande, c'est-à-dire que la capacité diminue lorsque la tension de commande du second condensateur variable Cv- augmente. La tension de commande est définie dans le sens conventionnel de tension de commande du type de condensateur variable utilisé.

En effet, la tension de commande Uv d'un condensateur variable est conventionnellement définie comme la différence de potentiel entre une borne négative et une borne positive du condensateur variable Cv, c'est-à-dire conformément à l'équation Uv=(Uneg-Upos).

Le condensateur variable est, par exemple, constitué par un transistor de type MOSFET dont la source et le drain sont reliés. La borne négative du condensateur variable est ainsi constituée par les drain et source reliés et la borne positive du condensateur variable est constituée par la grille du transistor. La tension de commande d'un MOSFET est définie par la tension Udg appliquée entre le drain et la grille, c'est-à-dire conformément à l'équation Udg=Vd-Vg.

Les condensateurs variables Cv+ et Cv- peuvent être constitués par tout moyen approprié et, plus particulièrement, par des varactors, de type diode ou de type transistor, ou par des capacités à base de MEMs. Le condensateur variable Cv+ dont la capacité varie dans le même sens que sa tension de commande peut notamment être constitué par un transistor PMOS. Le condensateur variable Cv- dont la capacité varie en sens inverse par rapport à sa tension de commande est, par exemple, constitué par un transistor NMOS. On utilise, de préférence, des transistors NMOS de type N+/N/N+ et des transistors PMOS de type P+/P/P+.

L'oscillateur 1 contrôlé en tension représenté à la figure 4 est un oscillateur à sortie différentielle et comporte, comme précédemment, un premier condensateur variable Cv+ et un second condensateur variable Cv- connectés en série et en opposition. L'ensemble des premier et second condensateurs variables Cv+ et Cv- est connecté, en parallèle avec l'inductance L, entre l'entrée 8 et la sortie de l'amplificateur 5. L'amplificateur 5 reçoit, à son entrée 8, un signal ayant une fréquence F2.

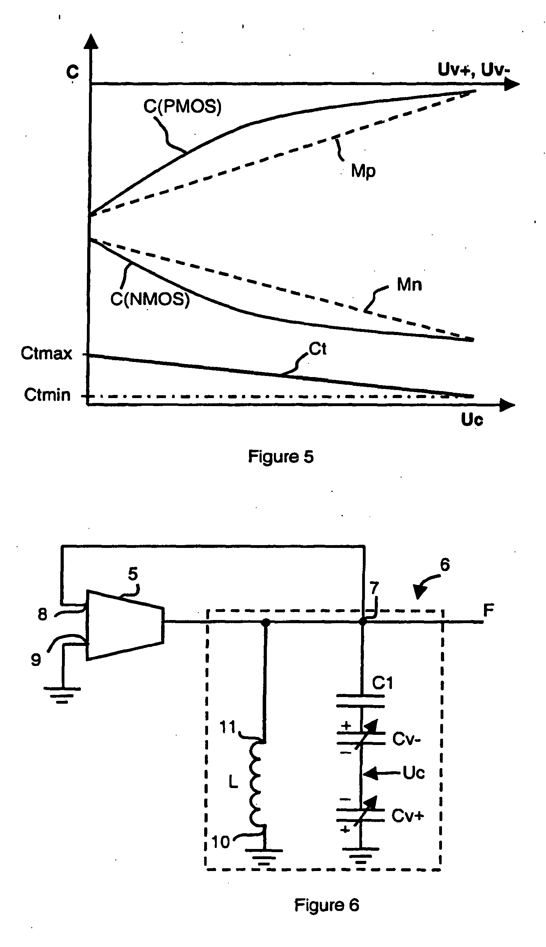

La figure 5 illustre un exemple des variations non-linéaires de la capacité de chacun des condensateurs variables Cv+ et Cv-, constitués respectivement par des transistors PMOS et NMOS, respectivement en fonction de leurs tensions de commande correspondantes Uv+ et Uv- (abscisse en haut de la figure 5).

La capacité C(PMOS) du condensateur PMOS augmente lorsque la tension Uv+ appliquée à ses bornes augmente, dans le sens conventionnel, Tandis que la capacité C(NMOS) du condensateur NMOS diminue lorsque la tension Uv- appliquée à ses bornes augmente.

La figure 5 illustre également, en fonction de la tension de contrôle Uc de l'oscillateur (abscisse en bas de la figure 5), les variations de la capacité totale Ct, c'est-à-dire la caractéristique capacité/tension, du réseau oscillant 6 représenté à la figure 3. La mise en série des premier (Cv+) et second (Cv-) condensateurs variables permet d'obtenir des variations sensiblement linéaires de la capacité totale Ct du réseau oscillant 6, en fonction de la tension de contrôle Uc. De plus, la pente de la courbe représentant la capacité totale Ct est inférieure, en valeur absolue, aux pentes moyennes Mp et Mn des courbes représentant respectivement les capacités C(PMOS) et C(NMOS) des condensateurs PMOS et NMOS. Ainsi, l'écart entre les valeurs minimale Ctmin et maximale Ctmax de la capacité totale Ct est plus faible que l'écart des valeurs extrêmes de chacune des capacités C(PMOS) et C(NMOS), ce qui permet d'obtenir un gain K plus faible et, ainsi, le bruit de phase est réduit.

La série des condensateurs variables Cv+ et Cv- présente alors une caractéristique capacité/tension commune linéaire et monotone sans discontinuité. De plus, cette série ne nécessite pas de changer les polarisations des condensateurs ou de commuter d'un condensateur à l'autre. La caractéristique capacité/tension commune a une pente constante sur une plage de la tension de contrôle Uc, par exemple comprise entre 0V et 1,2V, qui est supérieure à la plage de la tension de contrôle de l'art antérieur.

La figure 6 représente un circuit selon la figure 3 comportant, de plus, un condensateur C1 ayant une capacité fixe et connecté en série avec les premier et second condensateurs variables Cv+ et Cv-, notamment entre la borne 7 de rétroaction, d'une part, et l'ensemble formé par les condensateurs variables Cv+ et Cv-, d'autre part. Le condensateur C1 à capacité fixe peut aussi être placé en parallèle avec les condensateurs variables selon que l'on veut diminuer ou augmenter la capacité globale.

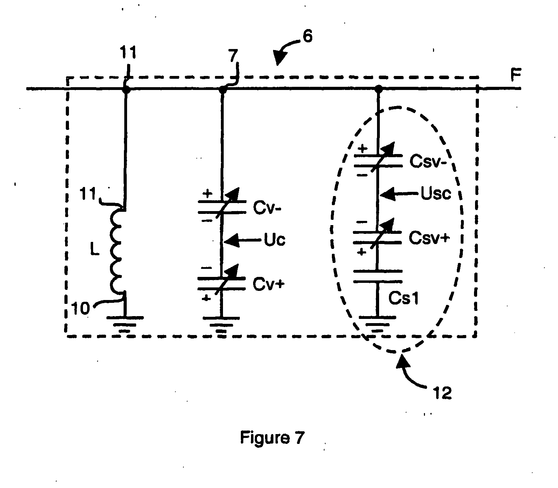

La figure 7 représente un circuit selon la figure 3 comportant, de plus, une série supplémentaire 12 connectée entre la masse et la borne 7 de rétroaction, en parallèle avec la série constituée par les premier (Cv+) et second (Cv-) condensateurs variables. La série supplémentaire 12 comporte au moins un premier condensateur variable supplémentaire Csv+ et un second condensateur variable supplémentaire Csv- connectés en opposition. Une tension de contrôle supplémentaire Usc est appliquée à la borne commune aux bornes négatives des premier et second condensateurs variables supplémentaires Csv+ et Csv-. La série supplémentaire 12 comporte, éventuellement, un condensateur supplémentaire Cs1 à capacité fixe. La capacité du premier condensateur variable supplémentaire Csv+ varie dans le même sens que sa tension de commande et la capacité du second condensateur variable supplémentaire Csv- varie en sens inverse par rapport à sa tension de commande. Comme précédemment, le condensateur supplémentaire Cs1 à capacité fixe peut aussi être connecté en parallèle avec l'ensemble des condensateurs variables supplémentaires.

L'invention n'est pas limitée aux modes de réalisation particuliers représentés. En particulier, les bornes positives des premier et second condensateurs variables peuvent être reliées à une borne commune (non-représenté), la tension de contrôle du réseau oscillant étant, comme précédemment, appliquée à la borne commune aux premier et second condensateurs variables.

Par ailleurs, un ou plusieurs condensateurs à capacité fixe (C1, C2, Cs1, etc...) peuvent être connectés entre le premier condensateur variable Cv+, d'une part, et le second condensateur variable Cv-, d'autre part, ou alors entre la masse, d'une part, et l'ensemble des condensateurs variables Cv+ et Cv-, d'autre part. Par ailleurs, une alternance de premiers (Cv+) et seconds (Cv-) condensateurs peut être connectée en série, par exemple entre la masse et la borne 7, éventuellement en combinaison avec des condensateurs à capacité fixe.

Dans un mode de réalisation non-représenté, plusieurs séries supplémentaires 12 sont connectées entre la borne 7 et la masse, chaque série comportant au moins des premier (Csv+) et second (Csv-) condensateurs variables supplémentaires et, éventuellement, des capacités fixes ou variables supplémentaires.

## Revendications

1. Oscillateur (1) contrôlé en tension comportant un amplificateur (5) et un réseau oscillant (6) comportant une inductance (L) et au moins des premier et second condensateurs variables (Cv) ayant chacun une capacité variant en fonction de sa tension de commande, oscillateur **caractérisé en ce que** les premier et second condensateurs variables sont connectés en série, la capacité de l'un des condensateurs variables (Cv+) variant dans le même sens que sa tension de commande et la capacité de l'autre condensateur variable (Cv-) variant en sens inverse par rapport à sa tension de commande.

2. Oscillateur selon la revendication 1, **caractérisé en ce que** les premier et second condensateurs variables (Cv+, Cv-), connectés en série, sont connectés en parallèle avec l'inductance entre les première et seconde bornes (10, 11) de l'inductance (L) et comportent une borne commune à laquelle est appliquée une tension de contrôle (Uc), la seconde borne (11) de l'inductance (L) étant connectée à la sortie de l'amplificateur (5).

3. Oscillateur selon la revendication 2, **caractérisé en ce que** la première borne (10) de l'inductance (L) est connectée à la masse, la sortie de l'amplificateur (5) constituant une borne de rétroaction (7) connectée à une première entrée (8) de l'amplificateur, dont une seconde entrée (9) est connectée à la masse.

4. Oscillateur selon la revendication 2, **caractérisé en ce que** la première borne (10) de l'inductance (L) est connectée à l'entrée (8) de l'amplificateur (5).

5. Oscillateur selon l'une quelconque des revendications 1 à 4, **caractérisé en ce que** les premier et second condensateurs variables (Cv+, Cv-) sont constitués par des transistors, respectivement de type PMOS et NMOS.

6. Oscillateur selon l'une quelconque des revendications 1 à 5, **caractérisé en ce qu'**au moins un condensateur (C1) ayant une capacité fixe est connecté en série ou en parallèle avec les premier et second condensateurs variables (Cv+, Cv-).

7. Oscillateur selon l'une quelconque des revendications 1 à 6, **caractérisé en ce qu'**au moins une série supplémentaire (12) de premier et second condensateurs variables supplémentaires (Csv+, Csv-) est connectée en parallèle avec les premier et second condensateurs variables (Cv+, Cv-).

8. Oscillateur selon la revendication 7, **caractérisé en ce qu'**au moins un condensateur supplémentaire (Cs1) ayant une capacité fixe est connecté en série ou en parallèle avec les premier et second condensateurs variables supplémentaires (Csv+, Csv-).

9. Oscillateur selon l'une quelconque des revendications 1 à 8, **caractérisé en ce que** les premier (Cv+) et second (Cv-) condensateurs variables sont connectés en opposition.

## Claims

1. Voltage controlled oscillator (1) comprising an amplifier (5) and an oscillating (6) system comprising an inductor (L) and at least first and second variable capacitors (Cv) each having a capacitance varying according to its control voltage, oscillator **characterized in that** the first and second variable capacitors are connected in series, the capacitance of one of the variable capacitors (Cv+) varying in the same direction as its control voltage and the capacitance of the other variable capacitor (Cv-) varying in the opposite direction to its control voltage.

2. Oscillator according to claim 1, **characterized in that** the first and second in series connected variable capacitors (Cv+, Cv-) are connected in parallel with the inductor between the first and second terminals (10, 11) of the inductor (L) and have a common terminal to which is applied a control voltage (Uc), the second terminal (11) of the inductor (L) being connected to the output of the amplifier (5).

3. Oscillator according to claim 2, **characterized in that** the first terminal (10) of the inductor (L) is grounded, the output of the amplifier (5) constituting a feedback terminal (7) connected to a first input (8) of the amplifier, a second input (9) of the amplifier being grounded.

4. Oscillator according to claim 2, **characterized in that** the first terminal (10) of the inductor (L) is connected to the input (8) of the amplifier (5).

5. Oscillator according to any one of claims 1 to 4, **characterized in that** the first and second variable capacitors (Cv+, Cv-) are formed by transistors, respectively of PMOS and NMOS type.

6. Oscillator according to any one of claims 1 to 5, **characterized in that** at least one capacitor (C1) having a fixed capacitance is connected in series or in parallel with the first and second variable capacitors (Cv+, Cv-).

7. Oscillator according to any one of claims 1 to 6, **characterized in that** at least one additional series (12) of additional first and second variable capacitors (Csv+, Csv-) is connected in parallel with the first and second variable capacitors (Cv+, Cv-).

8. Oscillator according to claim 7, **characterized in that** at least one additional capacitor (Cs1) having a fixed capacitance is connected in series or in parallel with the additional first and second variable capacitors (Csv+, Csv-).

9. Oscillator according to any one of the claims 1 to 8, **characterized in that** the first variable capacitor (Cv+) and the second variable capacitor (Cv-) are connected in opposition.

**Patentansprüche**

1. Spannungsgeregelter Oszillator (1), der einen Verstärker (5) und ein oszillierendes Netz (6) mit einer Induktivität (L) und mindestens einem ersten und einem zweiten variablen Kondensator (Cv) umfasst, die jeweils eine abhängig von ihrer Steuerspannung schwankende Kapazität haben, Oszillator, der **dadurch gekennzeichnet ist, dass** der erste und der zweite variable Kondensator in Serie geschaltet sind, wobei die Kapazität eines der variablen Kondensatoren (Cv+) in gleicher Richtung schwankt wie seine Steuerspannung und die Kapazität des anderen variablen Kondensators (Cv-) in entgegengesetzter Richtung bezogen auf seine Steuerspannung schwankt.

2. Oszillator nach Anspruch 1, **dadurch gekennzeichnet, dass** der erste und der zweite in Serie geschaltete variable Kondensatoren (Cv+, Cv-) in parallel mit der Induktivität zwischen den ersten und zweiten Anschlusspunkten (10, 11) der Induktivität (L) geschaltet sind und einen gemeinsamen Anschlusspunkt haben, an dem eine Kontrollspannung (Uc) angelegt wird, wobei der zweiten Anschlusspunkt (11) der Induktivität (L) am Verstärkerausgang verbunden ist.

3. Oszillator nach Anspruch 2, **dadurch gekennzeichnet, dass** der ersten Anschlusspunkt (10) der Induktivität (L) an Masse verbunden ist, der Ausgang des Verstärkers (5) einen Rückführungsanschluss bildet, der an einen ersten Verstärkereingang (8) verbunden ist, und ein zweiten Verstärkereingang (8) an Masse verbunden ist.

4. Oszillator nach Anspruch 2, **dadurch gekennzeichnet, dass** der ersten Anschlusspunkt (10) der Induktivität (L) am Eingang (8) des Verstärkers (5) verbunden ist.

5. Oszillator nach einem der Ansprüche 1 bis 4, **dadurch gekennzeichnet, dass** der erste und der zweite variable Kondensator (Cv+, Cv-) aus Transistoren bestehen, und zwar einem PMOS- bzw. NMOS-Transistor.

6. Oszillator nach einem der Ansprüche 1 bis 5, **dadurch gekennzeichnet, dass** mindestens ein Kondensator (C1) eine feste Kapazität hat, die in Serie oder parallel geschaltet ist mit den ersten und zweiten variablen Kondensatoren (Cv+, Cv-).

7. Oszillator nach einem der Ansprüche 1 bis 6, **dadurch gekennzeichnet, dass** mindestens eine zusätzliche Reihe (12) von ersten und zweiten variablen Kondensatoren (Csv+, Csv-) parallel geschaltet ist mit den ersten und zweiten variablen Kondensatoren (Cv+, Cv-).

8. Oszillator nach Anspruch 7, **dadurch gekennzeichnet, dass** mindestens ein zusätzlicher Kondensator (Cs1) mit einer festen Kapazität in Serie oder parallel geschaltet ist mit den ersten und zweiten zusätzlichen variablen Kondensatoren (Csv+, Csv-).

9. Oszillator nach einem der Ansprüche 1 bis 8, **dadurch gekennzeichnet, dass** der erste variable Kondensator (Cv+) und der zweite variable Kondensator (Cv-) gegenphasig geschaltet sind.

Figure 1 (Art antérieur)

Figure 2 (Art antérieur)

Figure 3

Figure 4

Figure 5

Figure 6

Figure 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 6396356 B
- US 6292065 B
- US 6657509 B